# EUROPEAN PATENT APPLICATION

(11) **EP 2 495 734 A1**
(43) Date of publication of application: **05.09.2012**
(21) Application number: 10826684.2
(22) Date of filing: 26.10.2010
(51) Int. Cl.: H01B 12/06, C01G 1/00, C01G 23/047, H01B 13/00

(54) **TAPE BASE MATERIAL FOR A SUPERCONDUCTING WIRE ROD, AND SUPERCONDUCTING WIRE ROD**

(30) Priority: 27.10.2009 JP 2009246007
(71) Applicant: Furukawa Electric Co., Ltd., Chiyoda-ku Tokyo 100-8322 (JP)
(72) Inventor: OKUNO, Yoshikazu, Tokyo 100-8322 (JP)
(74) Representative: Horn Kleimann Waitzhofer
(86) International application number: PCT/JP2010/068893
(87) International publication number: WO 2011/052552

(57) **Abstract**

Provided is a superconducting wire rod that is reduced in cost due to a thinner/simpler middle layer, without the properties of the superconducting wire rod (for example critical current properties) being negatively affected. A provided tape-shaped base material for superconducting wire rods comprises a diffusion preventing layer, which comprises an oxide of a group 4 (4A) element, formed on a substrate that contains iron, nickel, or chromium. Specifically, the diffusion preventing layer comprises TiO₂, ZrO₂, or HfO₂.

## Description

### Technical Field

The present invention relates to a tape-shaped base for a superconducting wire, and to a superconducting wire, used for a superconducting device, such as a superconducting cable and a superconducting magnet, and more particularly to the configuration of an intermediate layer formed on a metal substrate.

### Background Art

Conventionally, an RE-based superconductor (RE: rare earth element) is known as a type of high-temperature superconductor which shows superconductivity at liquid nitrogen temperature (77K) or higher. Particularly, an yttrium-based oxide superconductor (hereinafter referred to as Y-based superconductor or YBCO) expressed by a chemical formula of YBa₂Cu₃O_{7-y} is a typical example. Note that the Y-based superconductor includes a superconductor in which a part of yttrium is substituted by gadolinium (Gd) (for example, expressed as (Y + Gd) BCO) or the like.
Generally, a superconducting wire rod using a Y-based superconductor (hereinafter referred to as a Y-based superconducting wire rod) has a laminated structure in which a middle layer, a layer formed of a Y-based superconductor (hereinafter referred to as an Y-based superconducting layer), and a protection layer are formed in this order on a tape-shaped metal substrate.
This Y-based superconducting wire rod is manufactured by, for example, forming the middle layer which includes an oriented layer on a low-magnetic non-oriented metal substrate (for example, HASTELLOY (registered trademark) which is nickel base heat-resistant and corrosion-resistant alloy), and depositing the Y-based superconducting layer on the oriented layer by using a PLD (Pulsed Laser Deposition) method, a MOCVD (Metal Organic Chemical Vapor Deposition) method, or the like.

It is known that the voltage-current characteristics of such high-temperature superconducting wire rod largely depend on the crystal orientation of the superconductor, particularly on the biaxial orientation thereof. Therefore, in order to obtain a superconducting layer having high biaxial orientation, it is necessary to improve crystal properties of the middle layer which serves as a base. As one of the means to do so, an IBAD (Ion Bean Assisted Deposition) method is known by which the oriented layer is deposited by accumulating deposited particles from a deposition source while obliquely irradiating an assisting ion beam at the deposition surface.

On the other hand, in order to obtain high voltage-current characteristics of the superconducting wire rod, it is necessary to prevent diffusion of Fe, Ni, Cr and the like that are constituent elements of the metal substrate from reaching the superconducting layer. Generally, a diffusion preventing layer formed of alumina (Al₂O₃), GZO (Gd₂Zr₂O₇) or the like is formed on the metal substrate (for example, see Non-Patent Document 1). Also, being unknown whether to function as the diffusion preventing layer, a technique for forming a layer formed of yttria-stabilized zirconia (YSZ) between the metal substrate and the oriented layer has been proposed (for example, see Patent Documents 1 and 2).

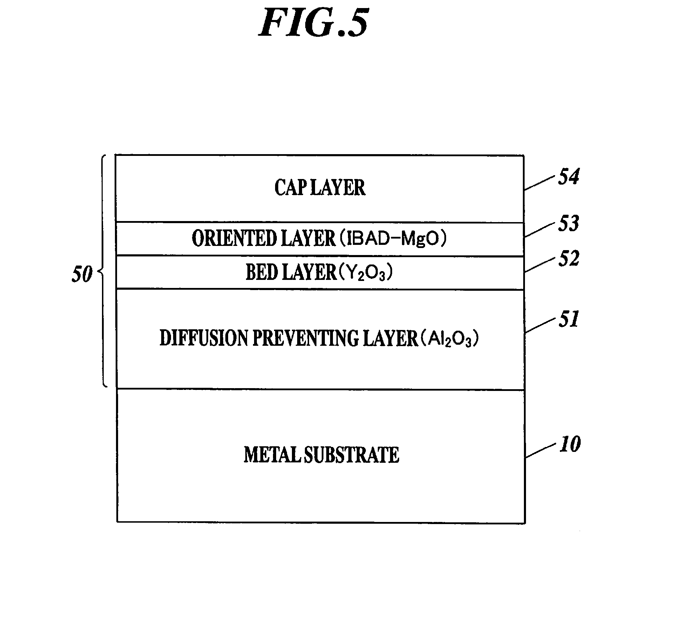

FIG. 5 is a view showing a structure of a conventional tape-shaped base material for a superconducting wire rod.
As shown in FIG. 5, when a diffusion preventing layer 51 is structured by Al₂O₃, a middle layer 50 is structured of the diffusion preventing layer 51, a bed layer 52, an oriented layer 53, and a cap layer 54. MgO readily reacts with Al₂O₃ and forms a Mg-Al-O compound (for example, MgAl₂O₄), and when the Mg-Al-O compound is formed, creation of an oriented layer of MgO is hampered. Accordingly, the bed layer 52 formed of yttria (Y₂O₃) or the like is inserted between the diffusion preventing layer 51 and the oriented layer 53.
Further, the cap layer 54 formed of ceria (CeO₂) or the like is formed on the oriented layer 53 in order to protect the oriented layer 53 formed of MgO which readily reacts with atmosphere, and to enhance lattice matching with a superconducting layer (for example, YBCO).
Note that, in a case where the diffusion preventing layer 51 is structured by GZO, the bed layer 52 is not necessary, however, the film thickness is to be more than that in the case where the diffusion preventing layer 51 is formed by Al₂O₃.

### Prior Art Documents

### Patent Documents

H11-503994
Patent document 1: Japanese Unexamined Patent Application Publication (Translation of PCT Application) No.
Patent document 2: Japanese Unexamined Patent Application Publication No. H6-271393

### Non-patent document

Non-patent document 1: "Continuous Fabrication of IBAD-MgO Based Coated Conductors" IEEE TRANSACTIONS ON APPLIED SUPERCONDUCTIVITY, Vol. 15, No. 2, JUNE 2005

### Summary of the Invention

### Problem to be solved by the Invention

As described earlier, since a diffusion preventing layer has been conventionally structured by Al₂O₃ or GZO, productivity of a superconducting wire rod is declined and cost reduction has been difficult. More specifically, since the temperature is as high as 800 to 900 degrees centigrade when forming a superconducting layer, diffusion of a constituent element of a substrate into the superconducting layer through a middle layer has been a problem. However, when the diffusion preventing layer is structured by Al₂O₃, it is necessary to have a film thickness of 80 nm or more, and, in addition, forming a bed layer is required in order to prevent diffusion of the constituent element of the substrate effectively. Further, when the diffusion preventing layer is structured by GZO, it is necessary to have a film thickness of 100 nm or more which is thicker than Al₂O₃ in order to prevent diffusion of the constituent element of the substrate effectively.

The present invention has been accomplished to solve the above-mentioned problems, and the objective thereof is to provide a tape-shaped base material for a superconducting wire rod and a superconducting wire rod that is reduced in cost due to a thinner/simpler middle layer without the properties of the superconducting wire rod (for example, critical current properties) being negatively affected.

### Means for solving the problems

The invention described in claim 1 is a tape-shaped base material for a superconducting wire rod, characterized by being formed with a diffusion preventing layer comprising an oxide of a group 4 (4A) element on a substrate which includes any one of iron (Fe), nickel (Ni), and chrome (Cr).

The invention described in claim 2 is the tape-shaped base material for a superconducting wire rod according to claim 1, characterized in that a film thickness of the diffusion preventing layer is 20 nm or more and not exceeding 70 nm.

The invention described in claim 3 is the tape-shaped base material for a superconducting wire rod according to claim 2, characterized in that the film thickness of the diffusion preventing layer is 20 nm or more and not exceeding 40 nm.

The invention described in claim 4 is the tape-shaped base material for a superconducting wire rod according to any one of claims 1 to 3, characterized in that the oxide of the group 4 (4A) element is any one of TiO₂, ZrO₂ and HfO₂.

The invention described in claim 5 is the tape-shaped base material for a superconducting wire rod according to any one of claims 1 to 4, characterized in that an average crystal grain size of the oxide of the group 4 (4A) element is larger than 50 nm.

The invention described in claim 6 is the tape-shaped base material for a superconducting wire rod according to any one of claims 1 to 5, characterized in that a bed layer formed of Y₂O₃ is formed on the diffusion preventing layer.

The invention described in claim 7 is the tape-shaped base material for a superconducting wire rod according to any one of claims 1 to 5, characterized in that an oriented layer is formed over the diffusion preventing layer.

The invention described in claim 8 is the tape-shaped base material for a superconducting wire rod according to claim 6, characterized in that the oriented layer is formed on the bed layer.

The invention described in claim 9 is the tape-shaped base material for a superconducting wire rod according to claim 7 or 8, characterized in that a cap layer is formed on the oriented layer.

The invention described in claim 10 is a superconducting wire rod characterized in that an oxide superconducting layer is formed on the tape-shaped base material for the superconducting wire rod according to any one of claims 7 to 9.

The present inventor invented an idea for reducing the film thickness of the diffusion preventing layer to shorten deposition time thereof by structuring the diffusion preventing layer with a substance having a better diffusion prevention function than Al₂O₃ and GZO which have been conventionally used, and sought a best-suited substance as the diffusion preventing layer.
Then, the inventor made a hypothesis that a main diffusion mechanism when Ni and the like is diffused into an oxide from the metal substrate is a vacancy mechanism due to vacancy generated as cation becomes absent within the oxide, and reached an conclusion to form the diffusion preventing layer with an oxide of an element which is quadrivalent cation.

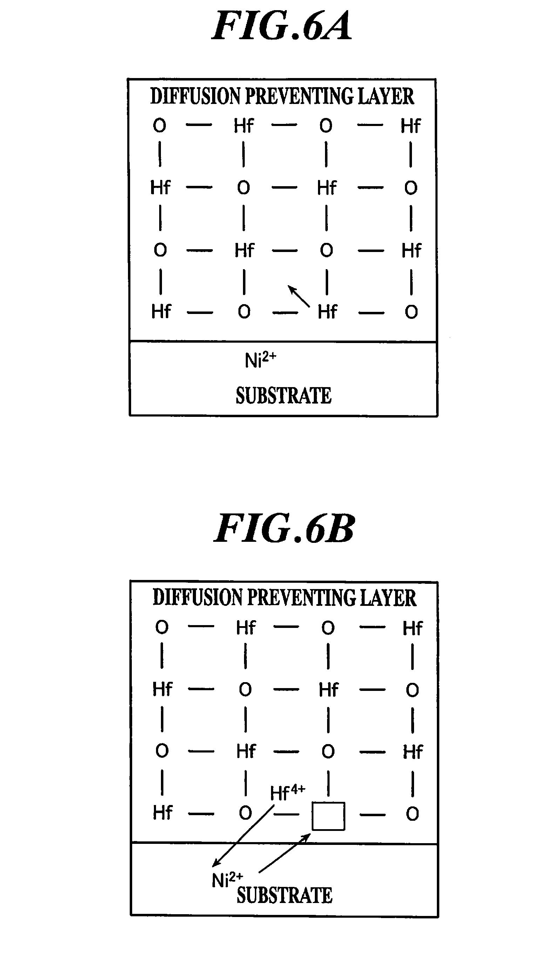

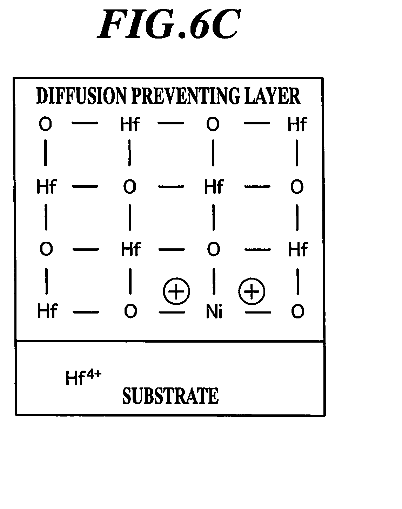

The case considered here is to form the diffusion preventing layer formed of an oxide of hafnium (Hf) (HfO₂) on the metal substrate which contains Ni. According to the hypothesis mentioned above, in the case where the diffusion preventing layer is structured of HfO₂, when vacancy is created as Hf⁴⁺ becomes absent (FIG. 6A), Ni ion moves into the vacancy (FIG. 6B). At this time, since the Ni ion is divalent or triad cation, substance with plus charge (for example, a hole) needs to be generated in the surroundings in order to maintain electro neutrality (FIG. 6C). However, extra energy is required to do so, and thus it is difficult for Ni to diffuse into HfO₂.
On the contrary, within Al₂O₃ or GZO, Ni is easily substituted by an element which is to be a divalent or triad cation.
Although mobility between Ni ion and Hf⁴⁺ is explained here, the same can be said for ion mobility between Fe ion (divalent or triad cation), Cr ion (triad cation) or the like in addition to Ni ion, and an element other than Hf which becomes quadrivalent cation.

Based on this finding, investigations were conducted on forming the diffusion preventing layer with an oxide of an element which becomes quadrivalent cation, and it was experimentally confirmed that, with an oxide of a group 4 (4A) element (so-called a titanium group element), a highly-functional diffusion preventing layer can be realized and a high superconductivity is secured when used as a superconducting wire rod.

### Effect(s) of the Invention

According to the tape-shaped base material for a superconducting wire rod of the present invention, since the diffusion preventing layer is structured by an oxide of a group 4 (4A) element, a thinner and simpler middle layer can be realized without superconductivity being negatively affected. Also, by using such tape-shaped base material for a superconducting wire rod, cost reduction of the superconducting wire rod can be realized.

### Brief Description of Drawings

[FIG. 1] This is a view showing a laminated structure of a superconducting wire rod according to an embodiment.
[FIG. 2] This is a view showing a structure of a tape-shaped base material for a superconducting wire rod according to the embodiment.
[FIG. 3] This is a view showing an example of a sputtering system used for deposition with a sputtering method or IBAD method.
[FIG. 4] This is a table showing critical current properties with respect to a film thickness of a diffusion preventing layer.
[FIG. 5] This is a view showing a structure of a conventional tape-shaped base material for a superconducting wire rod.
[FIG. 6A] This is a view showing a diffusion mechanism of Ni within HfO₂.
[FIG. 6B] This is a view showing a diffusion mechanism of Ni within HfO₂.
[FIG. 6C] This is a view showing a diffusion mechanism of Ni within HfO₂.

### Mode(s) for Carrying Out the Invention

Hereinafter, an embodiment of the present invention will be explained in detail with reference to the drawings.

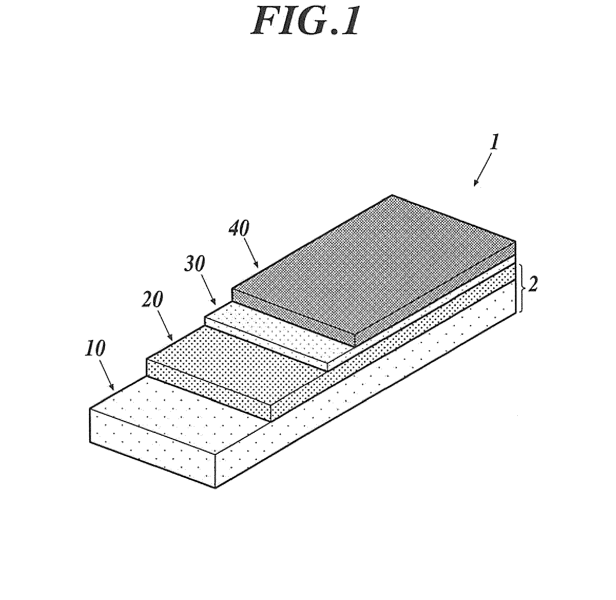

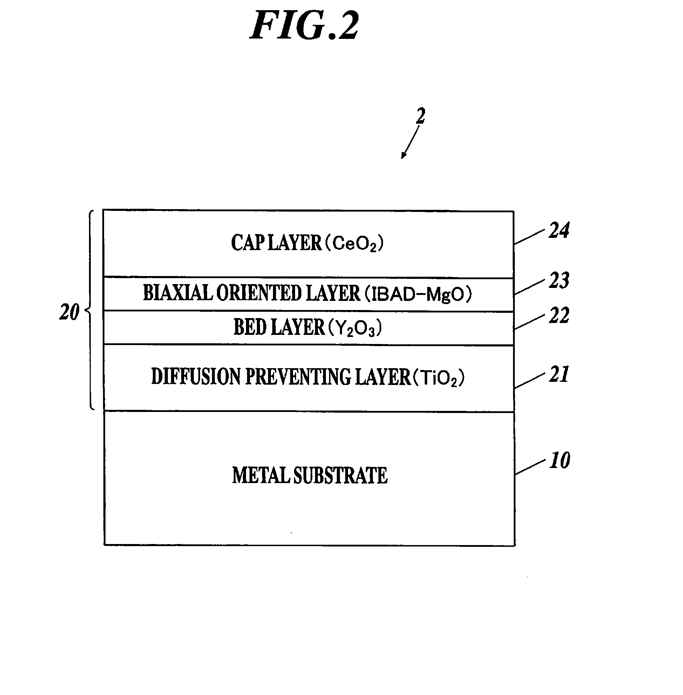

FIGS. 1 and 2 are views showing a laminated structure of a superconducting wire rod according to the present embodiment.
As illustrated in FIG. 1, an Y-based superconducting wire rod 1 has a laminated structure in which a middle layer 20, a superconducting layer 30, a protection layer 40 are formed in this order on a tape-shaped metal substrate 10. The tape-shaped metal substrate 10 and the middle layer 20 in FIG. 1 structure a tape-shaped base material 2 for a superconducting wire rod according to the present invention.
In this embodiment, the metal substrate 10 is a low-magnetic non-oriented metal substrate and may contain any one of iron (Fe), nickel (Ni), and chrome (Cr). For example, a HASTELLOY substrate which is nickel base heat-resistant and corrosion-resistant alloy contains all of Fe, Ni, and Cr.

As illustrated in FIG. 2, the middle layer 20 is constructed by having a diffusion preventing layer 21, a bed layer 22, an oriented layer 23 and a cap layer 24.
The diffusion preventing layer 21 is a layer which is intended for preventing a constituent element of the metal substrate 10 (for example, Fe, Ni, or Cr) from diffusing, and is deposited by using, for example, a sputtering method. In this embodiment, the diffusion preventing layer 21 is structured with an oxide of a group 4 (4A) element (for example, TiO₂, ZrO₂, or HfO₂). This makes it possible to reduce the film thickness of the diffusion preventing layer in comparison with the conventional case where the diffusion preventing layer is formed of Al₂O₃ or GZO, thus enabling to greatly improve productivity.
It is preferred that the film thickness of the diffusion preventing layer 21 is 20 nm or more and 70 nm or less. If the film thickness is less than 20 nm, diffusion of the constituent element of the metal substrate 10 cannot be prevented effectively, and if the film thickness is more than 70 nm, the deposition time becomes long, which causes productivity reduction. Also, by setting the film thickness to 40 nm or less, the productivity can be improved further.

Moreover, it is preferred that the diffusion preventing layer 21 is in a crystallized state. Here, the crystallized state means a state where the average crystal grain size of an oxide of the group 4 (4A) element is larger than 50 nm. When the diffusion preventing layer 21 is an amorphous state or a microcrystalline state (a state where the average crystal grain size is smaller than 50 nm), grain boundary diffusion or the like tends to occur, which makes it difficult to effectively suppress diffusion of Ni or the like.

The bed layer 22 is a layer formed of Y₂O₃ or the like which is intended for suppressing interference to biaxial orientation of the oriented layer 23 due to reaction with the diffusion preventing layer 21, and is deposited by using, for example, a sputtering method. The oriented layer 23 is a polycrystalline thin film formed of MgO in order to orient crystals of the superconducting layer 30 in a certain direction, and is deposited by using an IBAD method. The cap layer 24 is formed of CeO₂ or the like in order to protect the oriented layer 23 and also to improve lattice matching with the superconducting layer 30, and is deposited by using, for example, a sputtering method.
Note that, when the diffusion preventing layer 21 is structured with an oxide of the group 4 (4A) element, the bed layer 22 in FIG. 2 may be omitted.

The superconducting layer 30 is an Y-based superconducting layer formed of an Y-based superconductor, and is deposited by, for example, a metal organic chemical vapor deposition (MOCVD) method. On the upper surface of the superconducting layer 30, the protection layer 40 formed of silver is deposited by using, for example, a sputtering method.

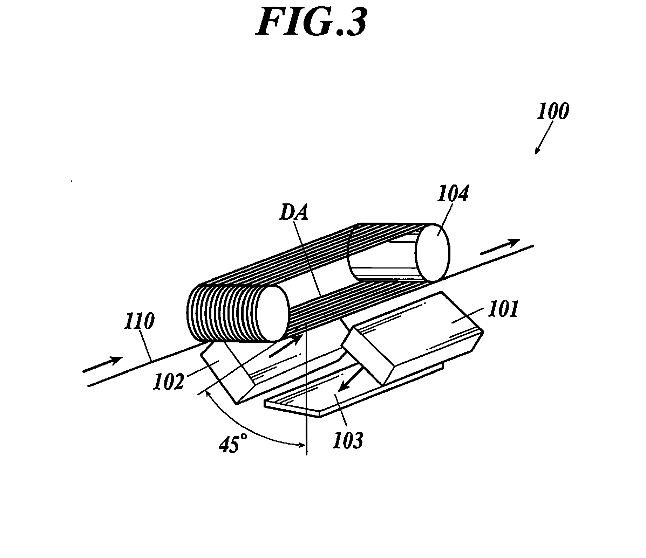

FIG. 3 is a view showing an example of a sputtering system used for deposition with a sputtering method or an IBAD method. As depicted in FIG. 3, the sputtering system 100 is structured by including a sputter ion source 101, an assist ion source 102, a target (deposition source) 103, and a base material conveying part 104. The sputtering system 100 is accommodated in a vacuum case (not illustrated), and is configured to accumulate deposited particles on the deposition surface DA in vacuum. Also, the sputtering system 100 has a non-illustrated heater and is configured to heat the deposition surface DA to a desired temperature.
When depositing the diffusion preventing layer 21, the tape-shaped metal substrate 10 serves as a base material 110, and when depositing the oriented layer 23, the diffusion preventing layer 21 and the bed layer 22 formed on the metal substrate 10 serve as the base material 110. The base material 110 is conveyed by the base material conveying part 104 into the sputtering system.

The sputter ion source 101 and the assist ion source 102 are provided with ion guns respectively which accelerate and emit ion generated by ion generators, and are configured to irradiate desired ion to a target 103 or a deposition surface DA.
For the target 103, a composition which is the same as or similar to the target diffusion preventing layer 21, the bed layer 22, or the oriented layer 23 is used. Alternatively, a metal element which constitutes the diffusion preventing layer 21, the bed layer 22, or the oriented layer 23 may be used as a target, and the diffusion preventing layer 21, the bed layer 22, or the oriented layer 23 may be deposited by reactive sputtering with oxygen.

Here, as ion species of the sputter ion and assist ion, Ar⁺ ion, for example, is used. Other than Ar⁺ ion, rare-gas ion such as helium (He), neon (Ne), xenon (Xe), and krypton (Kr), or mixed ion of such rare-gas ion and oxygen ion may also be used.

In depositing using the sputtering system 100, first, inside of the vacuum case is vacuumed to have reduced-pressure atmosphere, and then Ar gas is introduced therein. Thereafter, an ion beam is irradiated toward the target 103 from the sputter ion source 101 by activating a high-frequency power source. Then, constituent particles of the target 103 are sputtered and fly onto the deposition surface DA of the opposing base material 110. The particles which have flown (deposited particles) are accumulated on the deposition surface DA over a given period of time, thus forming a thin film. At this time, with the IBAD method, an assist ion beam is irradiated by the assist ion source 102 to the deposition surface DA of the base material 110 in an oblique direction (for example, at 45 degrees with respect to the normal direction of the deposition surface DA). Then the a axis and b axis of the polycrystalline thin film formed on the deposition surface DA of the base material 110 are oriented, thus forming the oriented layer. By depositing while moving the base material 110 by using the base material conveying part 104, a thin film can be formed uniformly on the long base material 110.

Described here is an example of deposition with the use of the ion beam sputtering method, however, other sputtering methods (for example, high-frequency sputtering method) may also be used. In a case of a sputtering system using a high-frequency sputtering method, the assist ion source 102 is the only ion source, and the sputter ion source 101 is not provided.

### [Example 1]

In the example 1, a tape-shaped HASTELLOY substrate 10 was used as the metal substrate 10. Surface polishing was conducted on the HASTELLOY substrate 10 by machine polishing or magnetic polishing so that the surface flatness Ra of the HASTELLOY substrate 10 becomes 2 nm. At this time, it is preferred that the surface flatness Ra of the metal substrate 10 be 5 nm or lower, more preferably 2 nm or lower.
Then, on the surface-polished HASTELLOY substrate 10, the diffusion preventing layer 21 formed of TiO₂ was deposited with the sputtering method at 20 degrees centigrade. The diffusion preventing layer 21 was formed to have film thicknesses of 15 nm, 20 nm, 30 nm, 40 nm, 60 nm, 70 nm, and 80 nm.
On the diffusion preventing layer 21, the bed layer 22 formed of Y₂O₃ was deposited to have 5 nm of thickness by the use of the sputtering method at 20 degrees centigrade.
Thereafter, on this bed layer 22, the oriented layer (IBAD-MgO layer) 23 formed of MgO was deposited to be 10 to 200 Å at room temperature. On the oriented layer 23, the cap layer 24 formed of CeO₂ was deposited to have 500 nm of thickness by using the sputtering method at 700 degrees centigrade. On the cap layer 24, the superconducting layer 30 formed of YBCO was deposited to have 1 µm of thickness by using the MOCVD method at 860 degrees centigrade. On the Y-based superconducting layer 30, the protection layer 40 formed of Ag was deposited. Then, oxygen annealing was conducted in oxygen ambient at 500 degrees centigrade, and the superconducting wire rod 1 according to the example 1 was fabricated.

### [Example 2]

The example 2 is different from the superconducting wire rod 1 of the example 1 in that the bed layer 22 is not formed. The film thickness of the diffusion preventing layer 21, and structures and the film thicknesses of the oriented layer 23, the cap layer 24, the superconducting layer 30 and the protection layer 40 are similar to those in the example 1.
Thus, in the example 2, after surface polishing was conducted on the tape-shaped HASTELLOY substrate 10 similarly to the example 1, the diffusion preventing layer 21 formed of TiO₂ was formed with the sputtering method at 20 degrees centigrade. Then, after the oriented layer 23, the cap layer 24, the superconducting layer 30, and the protection layer 40 are deposited on the diffusion preventing layer 21, oxygen annealing was conducted, thus fabricating the superconducting wire rod 1 according to the example 2.

### [Example 3]

The example 3 is different from the superconducting wire rod 1 of the example 1 in that the diffusion preventing layer 21 is formed of ZrO₂. The film thickness of the diffusion preventing layer 21, and structures and the film thicknesses of the bed layer 22, the oriented layer 23, the cap layer 24, the superconducting layer 30 and the protection layer 40 are similar to those in the example 1.
Thus, in the example 3, after surface polishing was conducted on the tape-shaped HASTELLOY substrate 10 similarly to the example 1, the diffusion preventing layer 21 formed of ZrO₂ was formed with the sputtering method at 20 degrees centigrade. Then, after the bed layer 22, the oriented layer 23, the cap layer 24, the superconducting layer 30, and the protection layer 40 are deposited on the diffusion preventing layer 21, oxygen annealing was conducted, thus fabricating the superconducting wire rod 1 according to the example 3.

### [Example 4]

The example 4 is different from the superconducting wire rod 1 of the example 1 in that the diffusion preventing layer 21 is formed of HfO₂. The film thickness of the diffusion preventing layer 21, and structures and the film thicknesses of the bed layer 22, the oriented layer 23, the cap layer 24, the superconducting layer 30 and the protection layer 40 are similar to those in the example 1.
Thus, in the example 4, after surface polishing was conducted on the tape-shaped HASTELLOY substrate 10 similarly to the example 1, the diffusion preventing layer 21 formed of HfO₂ was formed with the sputtering method at 20 degrees centigrade. Then, after the bed layer 22, the oriented layer 23, the cap layer 24, the superconducting layer 30, and the protection layer 40 are deposited on the diffusion preventing layer 21, oxygen annealing was conducted, thus fabricating the superconducting wire rod 1 according to the example 4.

### [Comparative Example]

The comparative example is different from the superconducting wire rod 1 of the example 1 in that the diffusion preventing layer 21 is formed of Al₂O₃. The film thickness of the diffusion preventing layer 21, and structures and the film thicknesses of the bed layer 22, the oriented layer 23, the cap layer 24, the superconducting layer 30 and the protection layer 40 are similar to those in the example 1.
Thus, in the comparative example, after surface polishing was conducted on the tape-shaped HASTELLOY substrate 10 similarly to the example 1, the diffusion preventing layer 21 formed of Al₂O₃ was formed with the sputtering method at 20 degrees centigrade. Then, after the bed layer 22, the oriented layer 23, the cap layer 24, the superconducting layer 30, and the protection layer 40 are deposited on the diffusion preventing layer 21, oxygen annealing was conducted, thus fabricating the superconducting wire rod 1 according to the comparative example.

With regard to the superconducting wire rods 1 fabricated in the examples 1 to 4 and the comparative example, the diffusion states of the constituent element (Fe, Ni, or Cr) of the metal substrates 10 into the middle layers 20 were confirmed. More specifically, the confirmation was carried out based on the detection states of the constituent element (Fe, Ni, or Cr) of the metal substrates 10 within the superconducting layers 30 at the points which are 900 nm from the topmost surfaces of the superconducting layers 30, in other words, the points which are approximately 100 nm from the topmost surfaces of the middle layers 20 in the thickness direction, by elemental analysis in the depth direction (the thickness direction of the superconducting wire rod 1) using SIMS (secondary ion mass spectrometry).

Then, from the detection result obtained, the diffusion states of the constituent element of the metal substrate 10 into the superconducting layers 30 were evaluated by rating the detected value of the constituent element of the metal substrates 10 (Fe, Ni, or Cr) as " X (x-marks)" when being larger than 1/1000 with respect to the detected value of Ba (barium), "Δ (triangles) " when being 1/5000 or larger but no larger than 1/1000, and "○ (circles)" when being smaller than 1/5000. Here, as the element serving as the criterial detected value (Ba), an element was selected which was not contained in the other constituent layers (the metal substrate 10 and the middle layer 20) among the constituent elements of the superconducting layer 30.

Further, with respect to the superconducting wire rods 1 fabricated in the examples 1 to 4 and the comparative example, critical currents were measured in liquid nitrogen using a four-terminal method with the voltage definition of 1 µV/cm. Then, the critical current properties (Ic properties) were evaluated by rating the critical current value as " × (x-marks)" when being 50A or smaller, "Δ (triangles)" when being over 50A but not exceeding 200A, and "O (circles) " when exceeding 200A.

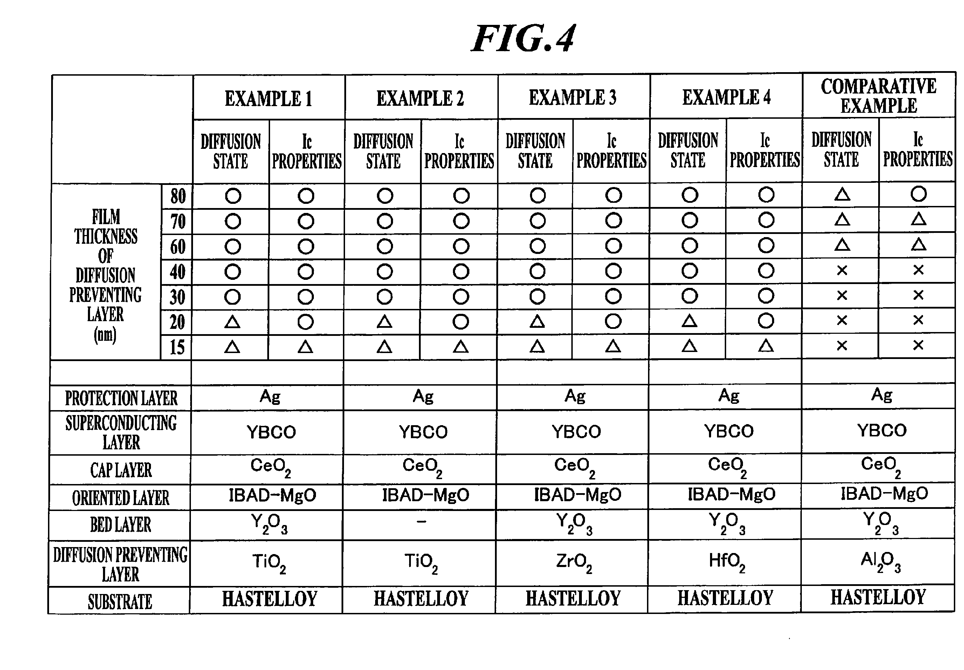

The results of the above-mentioned evaluations are shown in FIG. 4. As shown in FIG. 4, in the superconducting wire rods 1 of the examples 1 to 4, the constituent element of the metal substrates 10 (Fe, Ni or Cr) hardly diffused into the superconducting layers 30 even if the film thicknesses of the diffusion preventing layers 21 were 80 nm or less, and in particular, even if the film thickness was as thin as 30 nm, it was found that diffusion into the superconducting layers 30 did not happen.
Further, regarding the critical current properties, high critical current values were obtained when the film thicknesses of the diffusion preventing layers 21 were between 20 and 80 nm in the examples 1 to 4. The reason why the Ic properties were declined when the film thickness was 15 nm was because the film thickness is too thin to effectively suppress diffusion of Fe, Ni or Cr from the metal substrate 10, and the diffusion of Fe, Ni, or Cr expanded in the superconducting layer 30 on the side of the middle layer 20 (for example, the superconducting layer 30 which is 150 to 300 nm away from the topmost surface of the middle layer 20).

Although good Ic properties are obtained when the film thickness of the diffusion preventing layer 21 is 80 nm, the film thickness becomes a factor of productivity reduction, and thus it is desirable that the film thickness of the diffusion preventing layer be between 20 and 70 nm, and more preferably, between 20 and 40 nm.

It is evident from the example 2 that desired superconductivity can be secured without forming the bed layer 22 when the diffusion preventing layer 21 is made using TiO₂. This means that, by structuring the diffusion preventing layer 21 with TiO₂, a secondary effect can be provided that the bed layer 22 can be omitted.

Note that, described in the examples 3 and 4 was the case where the diffusion preventing layer 21 is structured by using ZrO₂ and HfO₂ as examples of an oxide of the group 4 (4A) element, and further, the bed layer 22 was formed, however, it is also confirmed that desired superconductivity can also be secured when the bed layer 22 is not formed similarly to the relation between the examples 1 and 2.

In the superconducting wire rod 1 of the comparative example, it was confirmed that the constituent element of the metal substrate 10 (Fe, Ni, or Cr) diffused into the superconducting layer 30 beyond the middle layer 20. Especially, when the film thickness of the diffusion preventing layer 21 is 40 nm or less, the constituent element of the metal substrate 10 (Fe, Ni, or Cr) was detected even in the vicinity of the topmost surface of the superconducting layer 30.
Further, with regard to the critical current properties, although a high critical current value was obtained when the film thickness of the diffusion preventing layer 21 was 80 nm, the critical current value was 200A or smaller when 70 nm or less. This shows that the Ic properties were deteriorated when the film thickness of the diffusion preventing layer 21 is 70 nm or less in the superconducting wire rod 1 of the comparative example. This is conceived to be because the diffusion preventing layer 21 formed of Al₂O₃ could not effectively suppress the diffusion of Fe, Ni, or Cr from the metal substrate 10, and diffusion of Fe, Ni or Cr expanded within the superconducting layer 30 on the side of the middle layer 20 (the superconducting layer 30 at approximately 150 to 300 nm away from the topmost surface of the middle layer 20).

Accordingly, it can be said that the diffusion prevention function of Al₂O₃ is lower than that of an oxide of a group 4 (4A) element (TiO₂, ZrO₂, or HfO₂). In other words, by structuring the diffusion preventing layer 21 with an oxide of the group 4 (4A) element (TiO₂, ZrO₂, or HfO₂) as in the examples 1 to 4, diffusion prevention function is sufficiently fulfilled with a small film thickness, thus enabling to reduce the film thickness of the diffusion preventing layer 21.

Note that, in the examples 1 to 4, since the thermal history at 700 degrees centigrade is given to the diffusion preventing layer 21 when forming the cap layer 24 formed of CeO₂, the diffusion preventing layer 21 is turned into a crystallized state. Therefore, when experiencing the thermal history while forming the superconducting layer at 860 degrees centigrade at which diffusion is most likely to happen, diffusion of the constituent element of the metal substrate 10 (Fe, Ni, or Cr) was able to be suppressed effectively.

As described so far, according to the tape-shaped base material 2 for a superconducting wire rod, according to the embodiment, since the diffusion preventing layer 21 is structured by an oxide of the group 4 (4A) element, thinner/simpler middle layer 20 can be realized. Also, according to the superconducting wire rod 1 using the tape-shaped base material 2 for a superconducting wire rod, a significant reduction in cost can be realized.

Although the invention accomplished by the present inventor has been specifically explained above based on the embodiment, the present invention shall not be limited the aforementioned embodiment, and changes may be made without departing from the gist thereof.
For example, for the metal substrate 10, a non-oriented metal substrate other than HASTELLOY such as SUS 304 may be applied.

It should be understood that the embodiment disclosed herein is shown as an example only in every aspect and not limitative. The scope of the present invention is represented not by the aforementioned descriptions but by the scope of claims, and it is intended that equivalent meanings to the scope of claims and all changes within the scope are included therein.

### Description of Numerals

- 10:: metal substrate (HASTELLOY)
- 20:: middle layer
- 21:: diffusion preventing layer (TiO₂, ZrO₂, HfO₂)
- 22:: bed layer (Y₂O₃)
- 23:: oriented layer (IBAD-MgO)
- 24:: cap layer (CeO₂)
- 30:: superconducting layer (YBCO)
- 40:: protection layer

## Claims

1. A tape-shaped base material for a superconducting wire rod, **characterized by** being formed with a diffusion preventing layer comprising an oxide of a group 4 (4A) element on a substrate which includes any one of iron (Fe), nickel (Ni), and chrome (Cr) .

2. The tape-shaped base material for a superconducting wire rod according to claim 1, **characterized in that** a film thickness of the diffusion preventing layer is 20 nm or more and not exceeding 70 nm.

3. The tape-shaped base material for a superconducting wire rod according to claim 2, **characterized in that** the film thickness of the diffusion preventing layer is 20 nm or more and not exceeding 40 nm.

4. The tape-shaped base material for a superconducting wire rod according to any one of claims 1 to 3, **characterized in that** the oxide of the group 4 (4A) element is any one of TiO₂, ZrO₂ and HfO₂.

5. The tape-shaped base material for a superconducting wire rod according to any one of claims 1 to 4, **characterized in that** an average crystal grain size of the oxide of the group 4 (4A) element is larger than 50 nm.

6. The tape-shaped base material for a superconducting wire rod according to any one of claims 1 to 5, **characterized in that** a bed layer formed of Y₂O₃ is formed on the diffusion preventing layer.

7. The tape-shaped base material for a superconducting wire rod according to any one of claims 1 to 5, **characterized in that** an oriented layer is formed over the diffusion preventing layer.

8. The tape-shaped base material for a superconducting wire rod according to claim 6, **characterized in that** the oriented layer is formed on the bed layer.

9. The tape-shaped base material for a superconducting wire rod according to claim 7 or 8, **characterized in that** a cap layer is formed on the oriented layer.

10. A superconducting wire rod **characterized in that** an oxide superconducting layer is formed on the tape-shaped base material for the superconducting wire rod according to any one of claims 7 to 9.
